# EUROPEAN PATENT APPLICATION

(11) **EP 4 322 217 A2**
(43) Date of publication of application: **14.02.2024**
(21) Application number: 23190506.8
(22) Date of filing: 09.08.2023
(51) Int. Cl.: H01L 25/075, H01L 33/50, H05B 45/20

(54) **LED HUMAN CENTRIC LIGHTING DEVICE AND METHOD FOR MANUFACTURING SAME**

(30) Priority: 11.08.2022 CN 202210962934; 11.08.2022 CN 202222117574 U
(71) Applicant: Ningbo Sunpu Led Co., Ltd., Hi-Tech Park Ningbo Zhejiang 315040 (CN)
(72) Inventor: Du, Yuanbao, Ningbo, 315040 (CN); Zhang, Yaohua, Ningbo, 315040 (CN); Wang, Guojun, Ningbo, 315040 (CN); Chen, Fusheng, Ningbo, 315040 (CN); Zhu, Xiaoqing, Ningbo, 315040 (CN); Zhang, Qinghao, Ningbo, 315040 (CN)
(74) Representative: Patentanwaltskanzlei Matschnig & Forsthuber OG

(57) **Abstract**

An LED human centric lighting device includes a substrate, an LED light emitting chipset and at least two blue light chipsets with different color temperatures arranged on the substrate, a fluorescent colloid and an enclosure. The LED light emitting chipset includes multiple LED light emitting chips, and each of the blue light chipsets includes multiple blue light emitting chips with same color temperature. Each of the blue light chipsets forms a color temperature light emitting area, and the different color temperature light emitting areas are separated by the enclosure. The substrate is provided with a control circuit for controlling light emission of the corresponding color temperature light emitting area, and the fluorescent colloid is arranged in the enclosure. The LED light emitting chip and at least two blue light emitting chips with different color temperatures are assembled in the device, which can reduce a volume of the device.

## Description

### FIELD

The present application relates to the technical field of lighting, and in particular to an LED human centric lighting device and a method for manufacturing the LED human centric lighting device.

### BACKGROUND

Human Centric Lighting technology refers to a perfect integration of light, climate and space through the lighting technology, which allows people to get support in physical, emotional and health aspects and meet humanized lighting needs of people in a specific application environment.

Human centric lighting specifically relates to melatonin in human body, which is a sleep hormone affecting sleep status of human body. Light with a wavelength of about 480nm has obvious inhibitory effect on melatonin. Under a stronger light with this wavelength, people may be in an excited state which is beneficial to their work and study, while a weaker light with this wavelength may have less influence on melatonin and help people fall asleep. At present, a light source with high color temperature is made into an individual lighting device to be applicable for work and study environment, and a light source with low color temperature is made into an individual lighting device to be applicable for leisure and relaxation environment, resulting in that the lighting device may only meet one demand and has poor flexibility, or the two devices are integrated into one lamp, leading to a large volume of the lamp.

Therefore, those skilled in the art should focus on how to solve the above technical problems.

### SUMMARY

An object of the present application is to provide an LED human centric lighting device and a method for manufacturing the LED human centric lighting device, so as to meet a need of various color temperatures and reduce a volume of the device.

In order to solve the above technical problems, an LED human centric lighting device is provided according to the present application, which includes a substrate, an LED light emitting chipset and at least two blue light chipsets with different color temperatures arranged on the substrate, a fluorescent colloid and an enclosure.

The LED light emitting chipset includes multiple LED light emitting chips, and each of the blue light chipsets includes multiple blue light emitting chips with same color temperature.

Each of the blue light chipsets forms a color temperature light emitting area, and the different color temperature light emitting areas are separated by the enclosure.

The substrate is provided with a control circuit for controlling light emission of the corresponding color temperature light emitting area, and the fluorescent colloid is arranged in the enclosure.

Optionally, the number of the blue light chipsets is two, and the LED light emitting chipset is arranged in the color temperature light emitting area with a relatively high color temperature.

Optionally, the LED light emitting chipset forms a light emitting area independently.

Optionally, the two color temperature light emitting areas are spaced apart on the substrate.

Optionally, the color temperature light emitting areas are symmetrically distributed on the substrate.

Optionally, a light emitting area formed by the LED light emitting chipset is located in a middle of the substrate, and the different color temperature light emitting areas are distributed on both sides of the light emitting area formed by the LED light emitting chipset.

Optionally, the different color temperature light emitting areas are symmetrically distributed with respect to the light emitting area formed by the LED light emitting chipset.

A method for manufacturing an LED human centric lighting device is also provided according to the present application, which includes:
arranging an LED light emitting chipset and at least two blue light chipsets with different color temperatures on a substrate, in which the LED light emitting chipset includes multiple LED light emitting chips, each of the blue light chipsets includes multiple blue light emitting chips with same color temperature and forms a color temperature light emitting area, and the substrate is provided with a control circuit for controlling the corresponding color temperature light emitting area to emit light;
forming an enclosure around each of the color temperature light emitting areas;
dispensing in the enclosure to form a fluorescent colloid, and obtaining the LED human centric lighting device.

Optionally, when the number of the blue light chipset is two, dispensing in the enclosure to form the fluorescent colloid inculdes:
dispensing in the enclosure around each of the color temperature light emitting areas respectively to form the fluorescent colloid.

Optionally, when the number of the blue light chipset is two, dispensing in the enclosure to form the fluorescent colloid includes:
dispensing in the enclosure around the color temperature light emitting area with a relatively lower color temperature to form the fluorescent colloid;
dispensing on a whole luminous surface of the substrate to form the fluorescent colloid.

An LED human centric lighting device is provided according to the present application, which includes a substrate, an LED light emitting chipset and at least two blue light chipsets with different color temperatures arranged on the substrate, a fluorescent colloid and an enclosure. The LED light emitting chipset includes multiple LED light emitting chips, and each of the blue light chipsets includes multiple blue light emitting chips with same color temperature. Each of the blue light chipsets forms a color temperature light emitting area, and different color temperature light emitting areas are separated by the enclosure. The substrate is provided with a control circuit for controlling light emission of the corresponding color temperature light emitting area, and the fluorescent colloid is arranged in the enclosure.

It can be seen that the LED human centric lighting device according to the present application is assembled with the LED light emitting chips and at least two blue light emitting chips with different color temperatures, which can greatly reduce the volume of the device. The blue light emitting chips with same color temperature form a color temperature light emitting area, and the control circuit may independently control the different color temperature light emitting areas, and may adjust different color temperatures as needed to meet different needs of day and night, which is very flexible and convenient.

In addition, a method for manufacturing the LED human centric lighting device with the above advantages is also provided according to the present application.

### BRIEF DESCRIPTION OF THE DRAWINGS

In order to more clearly illustrate technical solutions in embodiments of the present application or in the conventional technology, the drawings to be used in the description of the embodiments or the conventional technology are briefly described below. Apparently, the drawings in the following description show only some embodiments of the present application, and other drawings may be obtained by those skilled in the art from the drawings without any creative work.
FIG. 1 is a top view of an LED human centric lighting device according to an embodiment of the present application;
FIG 2 is a schematic view showing a distribution of different color temperature light emitting areas of an LED human centric lighting device according to an embodiment of the present application;
FIG. 3 is a top view of another LED human centric lighting device according to an embodiment of the present application;
FIG. 4 is a schematic view showing a distribution of different color temperature light emitting areas of another LED human centric lighting device according to an embodiment of the present application;
FIG. 5 is a flow chart of a method for manufacturing an LED human centric lighting device according to an embodiment of the present application.

Reference numerals in the drawings are listed as follows:

| | |
|---|---|
| 1, substrate; | 2, LED light emitting chip; |
| 3, first color temperature blue light chip; | |
| 4, second color temperature blue light chip; | 5, enclosure; |
| 6, first color temperature light emitting area; | |
| 7, second color temperature light emitting area; | |
| 8, light emitting area formed by the LED light emitting chipset independently. | |

### DETAILED DESCRIPTION OF THE EMBODIMENTS

In order to make the person skilled in the art have a better understanding of solutions of the present application, the present application is described in further detail hereinafter, in conjunction with the drawings and embodiments. Apparently, the described embodiments are only a portion of rather than all of the embodiments of the present application. Any other embodiments acquired by those skilled in the art based on the embodiments in the present application without any creative efforts fall within the protection scope of the present application.

Many specific details are illustrated in following description to facilitate a full understanding of the present application. The present application may be implemented in another manner rather than those described herein. Those skilled in the art can analogize without departing from the scope of the present application. Therefore, the present application is not limited to the embodiments disclosed hereinafter.

As described in the background, at present, a light source with high color temperature is made into a single lighting device to be applicable for work and study environment, and a light source with a low color temperature is made into a single lighting device to be applicable for leisure and relaxation environment, resulting in that the lighting device may only meet one demand and has poor flexibility, or the two devices are integrated into one lamp, leading to a large volume of the lamp.

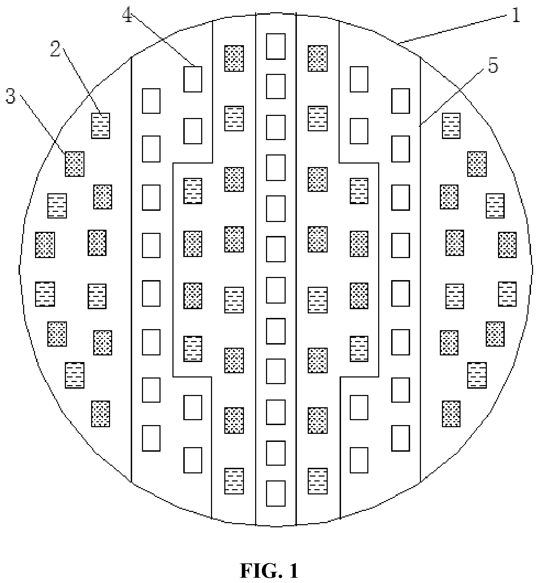

In view of this and with reference to FIG. 1 to FIG.4, an LED human centric lighting device is provided according to the present application, including:
a substrate 1, an LED light emitting chipset and at least two blue light chipsets with different color temperatures arranged on the substrate 1, a fluorescent colloid and an enclosure 5.

The LED light emitting chipset includes multiple LED light emitting chips 2, and each of the blue light chipsets includes multiple blue light emitting chips with same color temperature.

Each of the blue light chipsets forms a color temperature light emitting area, and the different color temperature light emitting areas are separated by the enclosure 5.

The substrate 1 is provided with a control circuit for controlling light emission of the corresponding color temperature light emitting area, and the fluorescent colloid is arranged in the enclosure 5.

The substrate 1 shown in the drawing is a local area corresponding to a light emitting surface. The number of LED light emitting chips 2 is set as required, and is not limited in the present application.

The LED light emitting chips 2 in the LED light emitting chipset and the blue light emitting chips in each of the blue light chipsets are both electrically connected with the substrate 1.

The number of the blue light chipsets may be set according to requirements of the color temperature. Generally, two blue light chipsets, in which one is warm color and the other is cold color, may meet the requirements. Of course, it is also possible to provide three or more blue light chipsets, which is not limited in the present application.

The following description takes two blue light chipsets as an example. For convenience of description, a blue light chip with a high color temperature among the two blue light chipsets is called a first color temperature blue light chip 3, and a corresponding formed color temperature light emitting area is called a first color temperature light emitting area 6, while a blue light chip with a low color temperature is called a second color temperature blue light chip 4, and a corresponding formed color temperature light emitting area is called a second color temperature light emitting area 7.

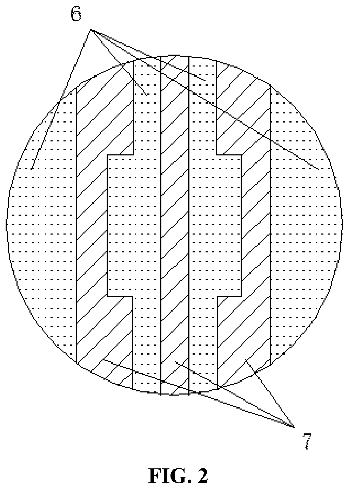

As an embodiment and with reference to FIG. 1 and FIG. 2, the number of the blue light chipsets is two, and the LED light emitting chipsets are arranged in the color temperature light emitting area with a high color temperature, that is, the LED light emitting chip 2 is arranged in the first color temperature light emitting area 6. The LED light emitting chip 2 and the first color temperature blue light chip 3 in the first color temperature light emitting area 6 are arranged based on a specific proportion, and the specific proportion depends on a certain situation. The LED light emitting chip 2 is a chip with a light emitting wavelength of 480nm.

In the LED human centric lighting device shown in FIG. 1, the LED light emitting chip 2 and the first color temperature blue light chip 3 in the first color temperature light emitting area 6 are controlled by a control circuit, and the second color temperature blue light chip 4 in the second color temperature light emitting area 7 is controlled by a control circuit. When light with a wavelength of 480nm is needed, that is, when people need to be excited, a first color temperature is controlled to be turned on, and when it is not needed, a second color temperature is turned on.

It should be noted that in this embodiment, the number of the first color temperature light emitting area 6 and the second color temperature light emitting area 7 is not limited. For example, the number of the first color temperature light emitting area 6 and the second color temperature light emitting area 7 may both be one, or the number of the first color temperature light emitting area 6 and the second color temperature light emitting area 7 may be two or more. When the number of the first color temperature light emitting area 6 and the second color temperature light emitting area 7 is two or more, the number of the first color temperature light emitting area 6 and the second color temperature light emitting area 7 may be equal or unequal, which are within the protection scope of the present application.

When the number of the first color temperature light emitting area 6 and the second color temperature light emitting area 7 is two or more, distribution of the two color temperature light emitting areas on the substrate 1 is not limited in this embodiment. For example, two of the color temperature light emitting areas are spaced apart on the substrate 1, as shown in FIG. 1. At this time, when a certain color temperature light emitting area is needed to emit light, intensity of light emitted by the LED human centric lighting device may be uniform in a lighting area. Alternatively, all of the first color temperature light emitting areas 6 are continuously distributed together, and all of the second color temperature light emitting areas 7 are continuously distributed together. Alternatively, the first color temperature light emitting areas 6 are distributed on both sides of the substrate 1, and all of the second color temperature light emitting areas 7 are located in a middle of the substrate 1, or other arrangements.

In order to further improve a uniformity of the intensity of the light emitted from the LED human centric lighting device in the lighting area, the color temperature light emitting areas are symmetrically distributed on the substrate 1. As shown in FIG. 1, the number of first color temperature light emitting area 6 is four, and the number of second color temperature light emitting area 7 is three, with one second color temperature light emitting area 7 arranged in the middle. The first color temperature light emitting areas 6 on both sides are symmetrical about the second color temperature light emitting area 7 in the middle, and the other two of the second color temperature light emitting areas are symmetrical about the second color temperature light emitting area 7 in the middle.

The fluorescent colloid includes a low color temperature fluorescent colloid and a high color temperature fluorescent colloid, and there are two distribution forms for the fluorescent colloid. First, the high color temperature fluorescent colloid is located in the enclosure 5 around the first color temperature light emitting area 6 with a relatively high color temperature to wrap the LED light emitting chip 2 and the first color temperature blue light chip 3, while the low color temperature fluorescent colloid is located in the enclosure 5 around the second color temperature light emitting area 7 with a relatively low color temperature to wrap the second color temperature blue light chip 4. Secondly, the low color temperature fluorescent colloid is located in the enclosure 5 around the second color temperature light emitting area 7 with a low color temperature, and the high color temperature fluorescent colloid is located on a whole light emitting surface of the substrate 1 to cover the low color temperature fluorescent colloid.

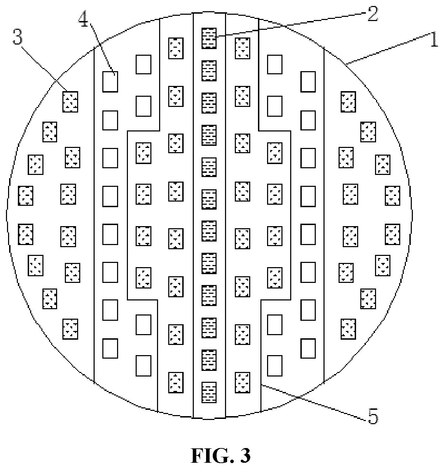

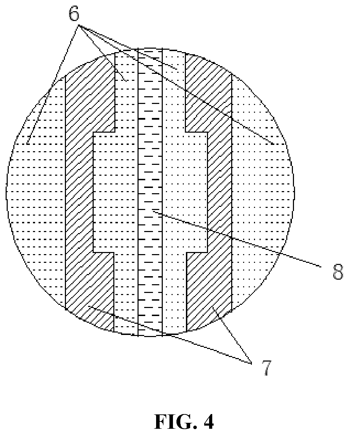

As another embodiment and with reference to FIG. 3 and FIG. 4, the LED light emitting chipset forms a light emitting area independently. At this time, the LED human centric lighting device includes three light emitting areas, namely, a light emitting area 8 formed by the LED light emitting chipset independently, a first color temperature light emitting area 6 and a second color temperature light emitting area 7. Among them, the light emitting area 8 formed by the LED light emitting chipset independently is controlled by a control circuit, the first color temperature blue light chip 3 in the first color temperature light emitting area 6 is controlled by a control circuit, and the second color temperature blue light chip 4 in the second color temperature light emitting area 7 is controlled by a control circuit. Therefore, the LED human centric lighting device in this embodiment has various light emitting modes, which may meet more needs for users. For example, it is possible to turn on the first color temperature light emitting area 6 alone, turn on the second color temperature light emitting area 7 alone, or turn on the light emitting area formed by the LED light emitting chipset alone, and it is also possible to turn on the first color temperature light emitting area 6 and the light emitting area formed by the LED light emitting chipset at the same time, or turn on the second color temperature light emitting area 7 and the light emitting area formed by the LED light emitting chipset at the same time. The LED light emitting chip 2 is a chip with a light emitting wavelength of 480nm, or, a chip with a wavelength of 480nm mixed with chips in other bands.

It should be noted that in this embodiment, the number of the first color temperature light emitting area 6 and the second color temperature light emitting area 7 is not limited. For example, the number of the first color temperature light emitting area 6 and the second color temperature light emitting area 7 may both be one, or the number of the first color temperature light emitting area 6 and the second color temperature light emitting area 7 may be two or more. When the number of the first color temperature light emitting area 6 and the second color temperature light emitting area 7 are two or more, the number of the first color temperature light emitting area 6 and the second color temperature light emitting area 7 may be equal or unequal, which are within the protection scope of the present application.

When the number of the first color temperature light emitting area 6 and the number of the second color temperature light emitting area 7 each are one, the arrangement of the light emitting area formed by the LED light emitting chipset, the first color temperature light emitting area 6 and the second color temperature light emitting area 7 on the substrate 1 in this embodiment is not limited, and may be set as required. For example, the light emitting area formed by the LED light emitting chipset is arranged in the middle and the other two light emitting areas with different color temperatures are arranged on both sides, or the first color temperature light emitting area 6 is arranged in the middle and the other two light emitting areas are arranged on both sides, or the second color temperature light emitting area 7 is arranged in the middle and the other two light emitting areas are arranged on both sides.

When the number of the first color temperature light emitting area 6 and the number of the second color temperature light emitting area 7 each are two or more, the distribution of the light emitting area formed by the LED light emitting chipset, the first color temperature light emitting area 6 and the second color temperature light emitting area 7 on the substrate 1 is not limited in this embodiment. For example, the light emitting area formed by the LED light emitting chipset is arranged in the middle of the substrate 1, and the different color temperature light emitting areas are distributed on both sides of the light emitting area formed by the LED light emitting chipset.

Further, in this embodiment, the distribution of the first color temperature light emitting area 6 and the second color temperature light emitting area 7 on both sides of the light emitting area formed by the LED light emitting chipset is not limited. For example, the different color temperature light emitting areas are symmetrically distributed with respect to the light emitting area formed by the LED light emitting chipset, as shown in FIG. 3 and FIG. 4. Alternatively, all of the first color temperature light emitting areas 6 are arranged on the same side, and all of the second color temperature light emitting areas 7 are arranged on the same side.

Preferably, in order to improve the uniformity of the intensity of the light emitted from the LED human centric lighting device in the lighting area, the different color temperature light emitting areas are symmetrically distributed with respect to the light emitting area formed by the LED light emitting chipset.

The fluorescent colloid includes a low color temperature fluorescent colloid and a high color temperature fluorescent colloid, and there are two distribution forms of the fluorescent colloid. First, the high color temperature fluorescent colloid is located in the enclosure 5 around the first color temperature light emitting area 6 with a relatively high color temperature to wrap the LED light emitting chip 2 and the first color temperature blue light chip 3, while the low color temperature fluorescent colloid is located in the enclosure 5 around the second color temperature light emitting area 7 with a relatively low color temperature to wrap the second color temperature blue light chip 4. Secondly, the low color temperature fluorescent colloid is located in the enclosure 5 around the second color temperature light emitting area 7 with a relatively low color temperature, and the high color temperature fluorescent colloid is located on the whole light emitting surface of the substrate 1 to cover the low color temperature fluorescent colloid.

The LED human centric lighting device according to the present application is assembled with the LED light emitting chip 2 and at least two blue light emitting chips with different color temperatures, which may greatly reduce the volume of the device. The blue light emitting chips with same color temperature form a color temperature light emitting area, and the control circuit may independently control the different color temperature light emitting areas, and may adjust different color temperatures as needed to meet different needs of day and night, which is very flexible and convenient.

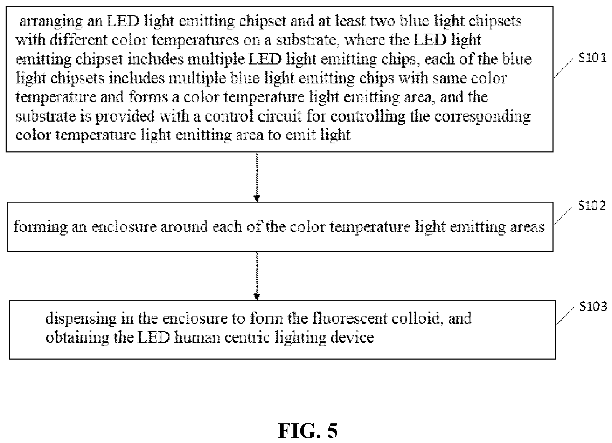

With reference to FIG. 5, a method for manufacturing an LED human centric lighting device is also provided according to the present application, which includes following steps S101 to S103.

Step S101, arranging an LED light emitting chipset and at least two blue light chipsets with different color temperatures on a substrate, in which the LED light emitting chipset includes multiple LED light emitting chips, each of the blue light chipsets includes multiple blue light emitting chips with same color temperature and forms a color temperature light emitting area, and the substrate is provided with a control circuit for controlling the corresponding color temperature light emitting area to emit light.

In the present application, when the blue light chipset with different color temperatures and the LED light emitting chipset are arranged on the substrate, positions of the blue light chipset with different color temperatures and the LED light emitting chipset are not limited.

When the number of blue light chipset is two, for the convenience of description, the blue light chip with a relatively high color temperature among the two blue light chipsets is called the first color temperature blue light chip, and the blue light chip with a relatively low color temperature is called the second color temperature blue light chip.

As an embodiment, arranging the LED light emitting chipset and at least two blue light chipsets with different color temperatures on the substrate includes:
arranging the LED light emitting chipset and the blue light chipset with a relatively high color temperature on the substrate to form a first color temperature light emitting area, and arranging the blue light chipset with a relatively low color temperature on the substrate to form a second color temperature light emitting area; in which the first color temperature light emitting area includes an LED light emitting chip and a first color temperature blue light chip, and the second color temperature light emitting area includes a second color temperature blue light chip.

The LED light emitting chip and the first color temperature blue light chip in the first color temperature light emitting area are controlled by a control circuit, and the second color temperature blue light chip in the second color temperature light emitting area is controlled by a control circuit.

As another embodiment, arranging the LED light emitting chipset and at least two blue light chipsets with different color temperatures on the substrate includes:
arranging two blue light chipsets on the substrate to correspondingly form a first color temperature light emitting area and a second color temperature light emitting area, where the first color temperature light emitting area includes a first color temperature blue light chip, and the second color temperature light emitting area includes a second color temperature blue light chip;
arranging the LED light emitting chipset on the substrate to form a single light emitting area;
in which the light emitting area formed by the LED light emitting chipset independently is controlled by a control circuit, the first color temperature blue light chip in the first color temperature light emitting area is controlled by a control circuit, and the second color temperature blue light chip in the second color temperature light emitting area is controlled by a control circuit.

Step S 102: forming an enclosure around each of the color temperature light emitting areas.

Step S103: dispensing in the enclosure to form fluorescent colloid, and obtaining the LED human centric lighting device.

Optionally, when the number of the blue light chipset is two, dispensing in the enclosure to form the fluorescent colloid includes:
dispensing in the enclosure around each of the color temperature light emitting areas respectively to form the fluorescent colloid, that is, dispensing high color temperature fluorescent colloid in the enclosure around the first color temperature light emitting area, and dispensing low color temperature fluorescent colloid in the enclosure around the second color temperature light emitting area.

It should be noted that when the LED light emitting chipset forms a light emitting area independently, and dispensing is conducted in the first color temperature light emitting area and the second color temperature light emitting area respectively, the step of arranging the LED light emitting chipset on the substrate to form a single light emitting area is carried out after dispensing is completed.

Optionally, when the number of the blue light chipset is two, dispensing in the enclosure to form the fluorescent colloid includes:
dispensing in the enclosure around the color temperature light emitting area with a relatively low color temperature to form the fluorescent colloid;
dispensing on a whole luminous surface of the substrate to form the fluorescent colloid.

That is, first dispensing the low color temperature fluorescent colloid in the second color temperature light emitting area, and then dispensing the high color temperature fluorescent colloid on the whole light emitting surface of the substrate.

The above embodiments are described in a progressive manner. Each of the embodiments is mainly focused on describing its differences from other embodiments, and references may be made among these embodiments with respect to the same or similar parts.

The LED human centric lighting device and the method for manufacturing the LED human centric lighting device according to the present application are described in detail hereinbefore. The principles and embodiments of the present application are clarified from specific embodiments herein, and the above description of the embodiments is only intended to facilitate understanding the method and the key concept of the present application. It should be noted that several improvements and modifications can be made to the present application by those skilled in the art without departing from the principles of the present application. These improvements and modifications shall fall within the scope of the claims of the present application.

## Claims

1. An LED human centric lighting device, comprising a substrate, an LED light emitting chipset and at least two blue light chipsets with different color temperatures arranged on the substrate, a fluorescent colloid and an enclosure;
wherein the LED light emitting chipset comprises a plurality of LED light emitting chips, and each of the blue light chipsets comprises a plurality of blue light emitting chips with same color temperature;
each of the blue light chipsets forms a color temperature light emitting area, and different color temperature light emitting areas are separated by the enclosure; and
the substrate is provided with a control circuit for controlling light emission of the corresponding color temperature light emitting area, and the fluorescent colloid is arranged in the enclosure.

2. The LED human centric lighting device according to claim 1, wherein the number of the blue light chipsets is two, and the LED light emitting chipset is arranged in the color temperature light emitting area with a relatively high color temperature.

3. The LED human centric lighting device according to claim 1, wherein the LED light emitting chipset forms a light emitting area independently.

4. The LED human centric lighting device according to claim 2, wherein the two color temperature light emitting areas are spaced apart on the substrate.

5. The LED human centric lighting device according to claim 4, wherein the color temperature light emitting areas are symmetrically distributed on the substrate.

6. The LED human centric lighting device according to claim 3, wherein a light emitting area formed by the LED light emitting chipset is located in a middle of the substrate, and the different color temperature light emitting areas are distributed on both sides of the light emitting area formed by the LED light emitting chipset.

7. The LED human centric lighting device according to claim 6, wherein the different color temperature light emitting areas are symmetrically distributed with respect to the light emitting areas formed by the LED light emitting chip set.

8. A method for manufacturing an LED human centric lighting device, comprising:
arranging an LED light emitting chipset and at least two blue light chipsets with different color temperatures on a substrate, wherein the LED light emitting chipset comprises a plurality of LED light emitting chips, each of the blue light chipsets comprises a plurality of blue light emitting chips with same color temperature and forms a color temperature light emitting area, and the substrate is provided with a control circuit for controlling the corresponding color temperature light emitting area to emit light;
forming an enclosure around each of the color temperature light emitting areas;
dispensing in the enclosure to form a fluorescent colloid, and obtaining the LED human centric lighting device.

9. The method for manufacturing an LED human centric lighting device according to claim 8, wherein when the number of the blue light chipset is two, dispensing in the enclosure to form the fluorescent colloid comprises:
dispensing in the enclosure around each of the color temperature light emitting areas respectively to form the fluorescent colloid.

10. The method for manufacturing an LED human centric lighting device according to claim 8, wherein when the number of the blue light chipset is two, dispensing glue in the enclosure to form the fluorescent colloid comprises:
dispensing in the enclosure around the color temperature light emitting area with a relatively low color temperature to form the fluorescent colloid;
dispensing on a whole luminous surface of the substrate to form the fluorescent colloid.
